# EUROPÄISCHE PATENTSCHRIFT

(11) **EP 0 925 607 B1**
(45) Veröffentlichungstag und Bekanntmachung des Hinweises auf die Patenterteilung: **27.02.2002**
(21) Anmeldenummer: 97936561.6
(22) Anmeldetag: 28.07.1997
(51) Int. Cl.: H01L 21/8242

(54) **VERFAHREN ZUR HERSTELLUNG EINER DRAM-ZELLENANORDNUNG**
METHOD FOR PRODUCING A DRAM CELLULAR ARRANGEMENT
PROCEDE DE PRODUCTION D'UNE MATRICE CELLULAIRE A DRAM

(30) Priorität: 13.09.1996 DE 19637389
(43) Veröffentlichungstag der Anmeldung: 30.06.1999
(73) Patentinhaber: Infineon Technologies AG, 81669 München (DE)
(72) Erfinder: RÖSNER, Wolfgang, D-81739 München (DE); RISCH, Lothar, D-85579 Neubiberg (DE); HOFMANN, Franz, D-80995 München (DE); STENGL, Reinhard, D-86391 Stadtbergen (DE)
(74) Vertreter: Barth, Stephan Manuel, Dr.
(86) Internationale Anmeldenummer: DE9701580
(87) Internationale Veröffentlichungsnummer: WO9811604

(56) Entgegenhaltungen:
- DE-A- 4 328 510
- DE-C- 19 519 160
- GB-A- 2 293 690
- US-A- 5 290 723
- US-A- 5 357 131
- PATENT ABSTRACTS OF JAPAN vol. 9, no. 140 (E-321), 14.Juni 1985 & JP 60 021558 A (MITSUBISHI DENKI KK), 2.Februar 1985,

## Beschreibung

Die vorliegende Erfindung betrifft ein Verfahren zur Herstellung einer DRAM-Zellenanordnung.

Aus der DE 195 19 160 ist ein Verfahren zur Herstellung einer DRAM-Zellenanordnung bekannt, bei dem auf ein Halbleitersubstrat, das eine erste Schicht, die von einem ersten Leitfähigkeitstyp dotiert ist, eine zweite Schicht, die von einem zweiten, zum ersten entgegengesetzten Leitfähigkeitstyp dotiert ist, und eine dritte Schicht, die vom ersten Leitfähigkeitstyp dotiert ist und an eine Hauptfläche des Halbleitersubstrats angrenzt, umfaßt, eine Maskenschicht aufgebracht wird und unter Verwendung der Maskenschicht als Ätzmaske Gräben, die jeweils streifenförmig sind und im wesentlichen'parallel verlaufen und die erste Schicht, die zweite Schicht und die dritte Schicht durchtrennen, geätzt werden.

Insbesondere wird bei diesem bekannten Verfahren eine erste SiO₂-Schicht abgeschieden und strukturiert, eine zweite SiO₂-Schicht mit im wesentlichen konformer Kantenbedeckung abgeschieden und anisotrop rückgeätzt, so daß an den Flanken der strukturierten ersten SiO₂-Schicht SiO₂-Spacer entstehen, durch die die Weite der Gräben definiert wird.

Weiterhin werden bei diesem bekannten Verfahren
- die Gräben mit einer ersten Isolationsstruktur aufgefüllt,
- zweite Gräben, die jeweils streifenförmig sind und im wesentlichen parallel verlaufen, die die ersten Gräben kreuzen und die bis in die erste Schicht hineinreichen, ohne die erste Schicht zu durchtrennen, geätzt,
- die zweiten Gräben mit einer zweiten Isolationsstruktur versehen,
- die Weite der zweiten Gräben größer als die Weite der ersten Gräben eingestellt,
- die ersten Isolationsstrukturen und die zweiten Isolationsstrukturen selektiv zu dem Halbleitermaterial geätzt, bis an den Flanken der ersten Gräben und der zweiten Gräben die Oberflächen der strukturierten zweiten Schicht und dritten Schicht freigelegt sind,
- ein Gateoxid gebildet, das mindestens die freiliegende Oberfläche der zweiten Schicht bedeckt,
- zur Bildung von Gateelektroden eine leitfähige Schicht mit im wesentlichen konformer Kantenabdeckung erzeugt, deren Dicke so bemessen wird, daß sie die ersten Gräben auffüllt, die zweiten Gräben jedoch nicht auffüllt und die anisotrop rückgeätzt wird, so daß an den Flanken der zweiten Gräben leitfähige Spacer entstehen und in den zweiten Gräben die Oberfläche der zweiten Isolationsstrukturen teilweise freigelegt wird, während die Oberfläche der ersten Isolationsstruktur in den ersten Gräben von leitfähigem Material bedeckt bleibt,
- eine dritte Isolationsstruktur erzeugt, die die Gateelektroden abdeckt,
- Speicherkondensatoren jeweils mit einem Speicherknoten erzeugt, der mit der strukturierten dritten Schicht elektrisch verbunden wird.

Aus der US-A-5,357,131 ist ein weiteres Herstellungsverfahren zur Herstellung von DRAM-Speicherzellen mit Grabenkondensatoren bekannt.

In DRAM-Zellenanordnungen, das heißt, Speicherzellenanordnungen mit dynamischem, wahlfreiem Zugriff, werden fast ausschließlich sogenannte Eintransistor-Speicherzellen eingesetzt. Eine Eintransistorspeicherzelle umfaßt einen Auslesetransistor und einen Speicherkondensator. In dem Speicherkondensator ist die Information in Form einer elektrischen Ladung gespeichert, die eine logische Größe, Null oder Eins, darstellt. Durch Ansteuerung des Auslesetransistors über eine Wortleitung kann diese Information über eine Bitleitung ausgelesen werden.

Da von Speichergeneration zu Speichergeneration die Speicherdichte zunimmt, muß die benötigte Fläche der Eintransistorspeicherzelle von Generation zu Generation reduziert werden. Da der Reduktion der Strukturgrößen durch die minimale in der jeweiligen Technologie herstellbare Strukturgröße F Grenzen ,gesetzt sind, ist dies auch mit einer Veränderung der Eintransistorspeicherzelle verbunden. So wurden bis zur 1MBit-Generation sowohl der Auslesetransistor als auch der Speicherkondensator als planare Bauelemente realisiert. Ab der 4MBit-Speichergeneration mußte eine weitere Flächenreduzierung durch eine dreidimensionale Anordnung von Auslesetransistor und Speicherkondensator erfolgen. Eine Möglichkeit besteht darin, den Speicherkondensator in einem Graben zu realisieren (siehe zum Beispiel K. Yamada et al, A deep trenched capacitor technology for 4 Mbit DRAMs, Proc. Intern. Electronic Devices and Materials IEDM 85, Seite 702).

Ferner ist vorgeschlagen worden (siehe zum Beispiel Y. Kawamoto et al, A 1,28 µm² Bit-Line Shielded Memory Cell Technology for 64 Mbit DRAMs Techn. Digest of VLSI Symposium 1990, Seite 13) den Speicherkondensator als Stapelkondensator, den sogenannten stacked capacitor, auszuführen. Dabei wird über den Wortleitungen eine Struktur aus Polysilizium, zum Beispiel eine Kronenstruktur oder ein Zylinder gebildet, der *mit* dem Substrat kontaktiert wird. Diese Polysiliziumstruktur bildet den Speicherknoten. Er wird mit Kondensatordielektrikum und Kondensatorplatte versehen. Dieses Konzept hat den Vorzug, daß es weitgehend mit einem Logikprozeß kompatibel ist.

Die Fläche für eine Speicherzelle eines DRAM in der 1GBit-Generation soll nur etwa 0,2 µm² betragen. Der Speicherkondensator müß dabei eine Kapazität von 20 bis 30 fF aufweisen. Eine derartige Kapazität ist bei einer Zellfläche, wie sie bei der 1GBit-Generation zur Verfügung steht, in einem Stapelkondensator nur mit einer relativ komplizierten Struktur der Polysiliziumstruktur machbar. Diese komplizierten Strukturen sind zusätzlich durch ihre Topologie immer schwieriger herstellbar.

Ferner ist vorgeschlagen worden, die pro Fläche erzielbare Kapazität durch Verwendung eines Dielektrikum mit einer hohen Dielektrizitätskonstante zu erhöhen. Als Dielektrikum mit hoher Dielektrizitätskonstante sind insbesondere Para- und Ferroelektrika geeignet (siehe zum Beispiel WO 93/12542).

Der Erfindung liegt das Problem zugrunde, ein Herstellverfahren für eine DRAM-Zellenanordnung anzugeben, die als Speicherzellen Eintransistorspeicherzellen umfaßt, mit dem die für die 1GBit-Generation erforderliche Packungsdichte erzielbar ist.

Dieses Problem wird gelöst durch ein Verfahren zur Herstellung einer DRAM-Zellenanordnung gemäß Anspruch 1. Weitere Ausgestaltungen der Erfindung gehen aus den übrigen Ansprüchen hervor.

Auf ein Halbleitersubstrat, das eine erste Schicht, die von einem ersten Leitfähigkeitstyp dotiert ist, eine zweite Schicht, die von einem zweiten, zum ersten entgegengesetzten Leitfähigkeitstyp dotiert ist, und eine dritte Schicht, die vom ersten Leitfähigkeitstyp dotiert ist und die an eine Hauptfläche des Halbleitersubstrats angrenzt, umfaßt, werden eine erste Maskenschicht und eine zweite Maskenschicht aufgebracht, die zueinander selektiv ätzbar sind. Die zweite Maskenschicht und die erste Maskenschicht werden gemeinsam strukturiert.

Durch selektives Ätzen wird die strukturierte erste Maskenschicht lateral unter die strukturierte zweite Maskenschicht zurückgeätzt. Anschließend wird die strukturierte zweite Maskenschicht entfernt.

An den Flanken der strukturierten ersten Maskenschicht werden Spacer aus einem Material gebildet, das zu dem Material der strukturierten ersten Maskenschicht selektiv ätzbar ist.

Es wird eine dritte Maskenschicht mit im wesentlichen konformer Kantenbedeckung aufgebracht, die die gleichen Ätzeigenschaften wie die die erste Maskenschicht aufweist. Die dritte Maskenschicht wird selektiv zu den Spacern zurückgeätzt, bis die Oberfläche der Spacer teilweise freigelegt ist. Dann werden die Spacer selektiv zur strukturierten ersten Maskenschicht und zur strukturierten dritten Maskenschicht entfernt.

Unter Verwendung der strukturierten ersten Maskenschicht und der strukturierten dritten Maskenschicht als Ätzmaske werden erste Gräben, die jeweils streifenförmig sind und im wesentlichen parallel verlaufen und die die erste Schicht, die zweite Schicht und die dritte Schicht durchtrennen, geätzt. Die ersten Gräben werden mit einer ersten Isolationsstruktur aufgefüllt.

Anschließend werden zweite Gräben, die jeweils streifenförmig sind und im wesentlichen parallel verlaufen, die die ersten Gräben kreuzen und die bis in die erste Schicht hineinreichen, ohne die erste Schicht zu durchtrennen, geätzt. Die zweiten Gräben werden mit einer zweiten Isolationsstruktur versehen.

Die ersten Isolationsstrukturen und die zweiten Isolationsstrukturen werden selektiv zu dem Halbleitermaterial geatzt, bis an den Flanken der ersten Gräben und der zweiten Gräben die Oberfläche der strukturierten zweiten Schicht und dritten Schicht freigelegt sind.

Dann wird ein Gateoxid gebildet, das mindestens die freiliegende Oberfläche der zweiten Schicht bedeckt. Anschließend wird zur Bildung von Gateelektroden eine leitfähige Schicht mit im wesentlichen konformer Kantenbedeckung erzeugt. Die leitfähige Schicht wird vorzugsweise aus dotiertem Polysilizium gebildet, da sich dieses Material mit guter Konformität abscheiden läßt. Sie kann alternativ aus Metallsilizid oder Metall, zum Beispiel Wolfram, oder aus einer Kombination dieser Materialien mit dotiertem Polysilizium gebildet werden.

Die ersten Gräben werden mit einer kleineren Weite als die zweiten Gräben erzeugt. Die Dicke der leitfähigen Schicht wird so bemessen, daß die leitfähige Schicht die ersten Gräben auffüllt, die zweiten Gräben jedoch nicht auffüllt. Durch anisotropes Rückätzen der leitfähigen Schicht wird in den zweiten Gräben die Oberfläche der zweiten Isolationsstruktur teilweise freigelegt. An den Flanken der zweiten Gräben verbleiben dabei dotierte leitfähige Spacer. Bei diesem anisotropen Rückätzen wird das in den ersten Gräben verbliebene leitfähige Material zwar ebenfalls angegriffen, die Oberfläche der ersten Isolationsstrukturen in den ersten Gräben bleibt jedoch mit leitfähigem Material bedeckt. Auf diese Weise ergeben sich die Gateelektroden als ringförmige Strukturen aus leitfähigem Material, wobei der jeweils in den ersten Gräben angeordnete Teil der Struktur zwei benachbarten Gateelektroden angehört und diese herstellungsgemäß miteinander verbindet.

Die Gateelektroden werden schließlich mit einer dritten Isolationsstruktur abgedeckt. Die dritte Isolationsstruktur füllt die ersten Gräben und die zweiten Gräben oberhalb der Gateelektroden im wesentlich vollständig auf. In den zweiten Gräben isoliert die dritte Isolationsstruktur an gegenüberliegenden Flanken angeordnete Gateelektroden. Anschließend wird das Kondensatordielektrikum und die Kondensatorplatte aufgebracht. Die dritte Isolationsstruktur wird vorzugsweise ebenfalls durch Abscheidung einer Schicht mit im wesentlichen konformer Kantenbedeckung und Rückätzen der Schicht erzeugt.

Zur selbstjustierenden Herstellung ist es wesentlich, daß sich die Weiten der ersten Gräben und der zweiten Gräben unterscheiden, so daß die leitfähige Schicht die ersten Gräben auffüllt, die zweiten Gräben jedoch nicht. Dadurch wird die Strukturierung der Gateelektroden, die gleichzeitig die Wortleitungen bilder., ohne photolithographische Schritte ermöglicht. In diesem Verfahren werden nur zwei photolithographische Schritte benötigt: die Strukturierung der ersten Maskenschicht und der zweiten Maskenschicht und die Ätzung der zweiten Gräben erfolgt jeweils mit einer lithographisch erzeugten Maske. Diese Masken sind bezüglich ihrer Justierung jedoch völlig unkritisch.

Die strukturierte dritte Schicht bildet ein erstes Source/Drain-Gebiet von vertikalen MOS-Transistoren, die jeweils die Auslesetransistoren der Eintransistorspeicherzellen der DRAM-Zellenanordnung darstellen. Die strukturierte erste Schicht bildet vergrabene Bitleitungen und daran angrenzende zweite Source/Drain-Gebiete der vertikalen MOS-Transistoren.

Zwischen dem ersten Source/Drain-Gebiet und dem zweiten Source/Drain-Gebiet bildet die strukturiertte zweite Schicht ein Kanalgebiet, das von dem Gateoxid und der Gateelektrode ringförmig umgeben wird. Die Gateelektroden von entlang einer Wortleitung benachbarten vertikalen MOS-Transistoren grenzen aneinander an und bilden gemeinsam die Wortleitung.

Der Speicherkondensator der Eintransistorspeicherzellen wird jeweils oberhalb der Hauptfläche gebildet. Er umfaßt einen Speicherknoten, der mit dem ersten Source/Drain-Gebiet elektrisch verbunden ist. Der Speicherknoten kann sowohl planar als auch als mehr oder weniger komplizierte Polysiliziumstruktur, wie es von den Stapelkondensatoren her bekannt ist, ausgebildet sein.

Auf der Hauptfläche wird gemäß einer Ausführungsform an der Oberfläche des dort angrenzenden, ersten Source/Drain-Gebietes ein Kondensatordielektrikum und darüber eine Kondensatorplatte gebildet. Das an die Hauptfläche angrenzende erste Source/Drain-Gebiet wird in dieser Ausführungsform zusätzlich als Speicherknoten für den aus Kondensatorplatte, Kondensatordielektrikum und Source/Drain-Gebiet gebildeten Speicherkondensator verwendet. Um bei einer kleinen Fläche des Speicherknotens eine ausreichende Kapazität zu erzielen, ist es dabei vorteilhaft, als Kondensatordielektrikum ein Material mit einer relativen Dielektrizitätskonstante im Bereich zwischen 100 und 1000 zu verwenden.

Die DRAM-Zellenanordnung wird vorzugsweise in einem Halbleitersubstrat realisiert, das mindestens in dem Bereich für die DRAM-Zellenanordnung monokristallines Silizium umfaßt. Das kann sowohl eine Scheibe durchgehend aus monokristallinem Silizium als auch ein SOI-Substrat, das auf einer Siliziumscheibe eine isolierende Schicht und darauf eine dünne monokristalline Siliziumschicht umfaßt, sein.

Die erfindungsgemäße DRAM-Zellenanordnung kann bei Verwendung des ersten Source/Drain-Gebietes als Speicherknoten mit einer planaren Oberfläche oder mit einer Oberfläche mit einer flachen Topologie hergestellt werden, so daß *als* Kondensatordielektrikum eine ferroelektrische Schicht oder paraelektrische Schicht verwendet werden kann. Ferroelektrische und paraelektrische Schichten weisen eine hohe relative Dielektrizitätskonstante εᵣ im Bereich von 500 bis 1000 auf. Wenn diese Schichten durch Sputtern abgeschieden werden, sind sie nur auf ebenen Oberflächen oder Oberflächen mit einer flachen Topologie einsetzbar. Auch bei CVD- oder Sol-Gel-Verfahren mit besserer Kantenbedeckung können durch die benötigte Dicke der Schichten keine komplizierten 3D-Strukturen hergestellt werden. Als Kondensatordielektrikum wird vorzugsweise Barium-Strontium-Titanat, Strontium-Titanat oder Blei-Zirkon-Titanat verwendet. Ferner sind die aus WO 93/12542 bekannten Materialien als Kondensatordielektrikum geeignet. Mit diesen Dielektrika mit hoher relativer Dielektrizitätskonstante kann die erforderliche Kapazität von 20 bis 30 fF auch auf einer Fläche von etwa 0,1 bis 0,4 µm² erzielt werden.

In dem erfindungsgemäßen Verfahren können die ersten Gräben mit einer Weite hergestellt werden, die geringer ist, als es der minimal herstellbaren Strukturgröße F in der jeweiligen Technologie entspricht. Wird die erste Maskenschicht und die zweite Maskenschicht streifenförmig mit einer Streifenbreite und einem Streifenabstand von einer minimalen Strukturgröße F, zum Beispiel 0,25 µm, in der jeweiligen Technologie strukturiert, beträgt die Weite der ersten Gräben weniger als F/2, da als Maske die strukturierte erste Maskenschicht gemeinsam mit der strukturierten dritten Maskenschicht verwendet wird und die Strukturgrößen in der strukturierten ersten Maskenschicht und der strukturierten dritten Maskenschicht durch das Unterätzen der strukturierten ersten Maskenschicht, die Bildung der Spacer, die selbstjustierte Bildung der strukturierten dritten Maskenschicht und das Entfernen der Spacer unter F/2 reduziert werden.

Beträgt auch die Weite der zweiten Gräben eine minimale Strukturgröße F, zum Beispiel 0,25 µm, in der jeweiligen Technologie, so läßt sich die DRAM-Zellenanordnung mit einem Platzbedarf pro Speicherzelle von 2F² herstellen.

Es liegt im Rahmen der Erfindung, die Gebiete für die Source/Drain-Gebiete und das Kanalgebiet sowie die Bitleitungen als ganzflächige Schichten epitaktisch aufzuwachsen. Dabei kann, bei Verwendung eines Substrats, das im Bereich der DRAM-Zellenanordnung monokristallines Silizium umfaßt, zur Verbesserung der Leitfähigkeit der Bitleitungen unter den zweiten Source/Drain-Gebieten eine leitfähige Schicht aus epitaktisch aufgewachsenem CoSi₂ erzeugt werden. Diese leitfähige Schicht wird bei der Ätzung der ersten Gräben ebenfalls durchtrennt und ist Bestandteil der Bitleitungen.

Im folgenden wird die Erfindung anhand eines Ausführungsbeispiels, das in den Figuren dargestellt ist, näher erläutert.
- Figur 1: zeigt ein Halbleitersubstrat mit einer strukturierten ersten Maskenschicht und einer strukturierten zweiten Maskenschicht.
- Figur 2: zeigt das Halbleitersubstrat nach Bildung einer Ätzstopschicht, Spacern und einer dritten Maskenschicht.
- Figur 3: zeigt das Halbleitersubstrat nach Strukturierung der dritten Maskenschicht, Entfernung der Spacer und Ätzung erster Gräben.
- Figur 4: zeigt einen Schnitt senkrecht zu dem in Figur 3 gezeigten Schnitt durch das Halbleitersubstrat nach der Ätzung zweiter Gräben und Auffüllung der zweiten Gräben.
- Figur 5: zeigt den in Figur 4 gezeigten Schnitt durch das Halbleitersubstrat nach der Bildung eines Gateoxids und der Abscheidung einer dotierten Polysiliziumschicht.
- Figur 6: zeigt den in Figur 5 gezeigten Schnitt durch das Halbleitersubstrat nach Bildung der Gateelektrode und Fertigstellung der Speicherkondensatoren.
- Figur 7: zeigt den in Figur 6 mit VII-VII bezeichneten Schnitt durch das Halbleitersubstrat.
- Figur 8: zeigt den in Figur 7 mit VIII-VIII bezeichneten Schnitt durch das Halbleitersubstrat.

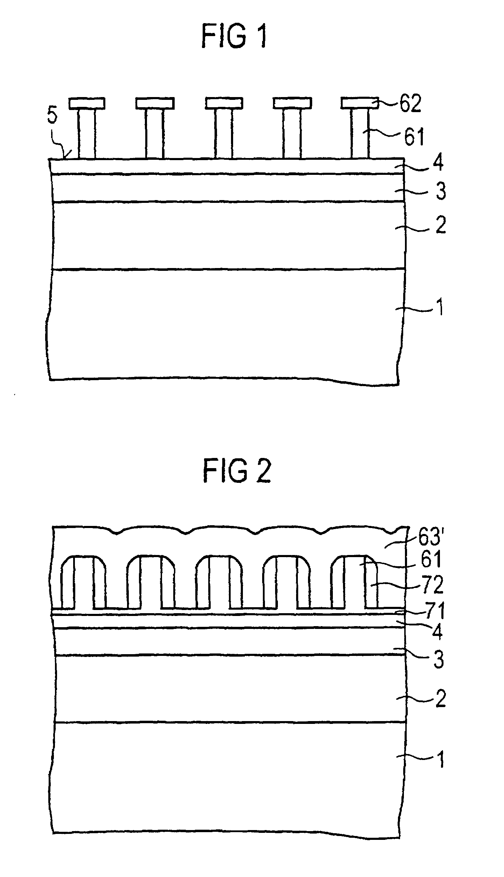

Ausgangsmaterial ist ein Substrat mit einem Bereich 1 aus zum Beispiel p-dotiertem, monokristallinem Silizium mit einer Dotierstoffkonzentration von zum Beispiel 10¹⁷ cm⁻³, das mit einer ersten Schicht 2 aus n⁺-dotiertem Silizium mit einer Dotierstoffkonzentration von zum Beispiel 10²⁰ cm⁻³, mit einer zweiten Schicht 3 aus p-dotiertem Silizium mit einer Dotierstoffkonzentration von zum Beispiel 3 x 10¹⁷ cm⁻³ und einer dritten Schicht 4 aus n⁺-dotiertem Silizium mit einer Dotierstoffkonzentration von zum Beispiel 10²¹ cm⁻³ versehen ist (siehe Figur 1). Die erste Schicht 2, die zweite Schicht 3 und die dritte Schicht 4 werden vorzugsweise durch epitaktisches Aufwachsen erzeugt. Die dritte Schicht 4 bildet eine Hauptfläche 5 des Substrats. Die erste Schicht 2 weist eine Dicke von zum Beispiel 500 nm, die zweite. Schicht 3 eine Dikke von zum Beispiel 200 nm und die dritte Schicht 4 eine Dikke von zum Beispiel 100 nm auf.

Auf die Hauptfläche 5 werden eine erste Maskenschicht 61 und eine zweite Maskenschicht 62 aufgebracht und strukturiert. Die erste Maskenschicht 61 wird zum Beispiel aus SiO₂ in einem TEOS-Verfahren in einer Dicke von 400 nm abgeschieden. Die zweite Maskenschicht 62 wird zum Beispiel aus Si₃N₄ in einem CVD-Verfahren in einer Dicke von 50 nm abgeschieden.Zur Strukturierung der ersten Maskenschicht 61 und der zweiten Maskenschicht 62 wird eine Photolackmaske (nicht dargestellt) verwendet. Die Strukturierung erfolgt in einem Trockenätzprozeß unter Verwendung von CHF₃, O₂. Dabei wird die Hauptfläche 5 freigelegt.

Nach Entfernen der Photolackmaske wird durch selektives, zum Beispiel naßchemisches Ätzen mit NH₄F, HF die strukturierte erste Maskenschicht 61 um zum Beispiel 65 nm unter die Kanten der strukturierten zweiten Maskenschicht 62 zurückgeätzt.

Nach Entfernen der strukturierten zweiten Maskenschicht 62 wird eine Ätzstopschicht 71 aus zum Beispiel SiO₂ in einem TEOS-Verfahren in einer Dicke von 20 nm abgeschieden. Dann werden an senkrechten Flanken der strukturierten ersten Maskenschicht 61 Spacer 72 aus zum Beispiel Si₃N₄ gebildet. Dazu wird eine Si₃N₄-Schicht in einem CVD-Verfahren in einer Schichtdicke von zum Beispiel 90 nm abgeschieden. Durch anisotropes Trockenätzen selektiv zu SiO₂ zum Beispiel mit CHF₃, O₂ werden die Spacer 72 gebildet (siehe Figur 2). Die Spacer 72 können auch aus Polysilizium gebildet werden.

Anschließend wird eine dritte Maskenschicht 63' zum Beispiel aus SiO₂ in einem TEOS-Verfahren in einer Dicke von 200 nm abgeschieden. Die dritte Maskenschicht 63' füllt die Zwischenräume zwischen benachbarten Spacern 72 vollständig auf.

Durch anisotropes Trockenätzen zum Beispiel mit CHF₃, O₂ wird die dritte Maskenschicht 63' durch Rückätzen strukturiert. Der Ätzvorgang wird solange fortgesetzt, bis die Oberfläche der Spacer 72 im oberen Bereich freigelegt ist. Anschließend werden die Spacer 72 selektiv zur strukturierten dritten Maskenschicht 63 und zur strukturierten ersten Maskenschicht 61 zum Beispiel naßchemisch mit H₃PO₄ bei 155°C entfernt. Dabei wird zwischen den Teilen der strukturierten ersten Maskenschicht 61 und der strukturierten dritten Maskenschicht 63 die Oberfläche der Ätzstopschicht 71 freigelegt.

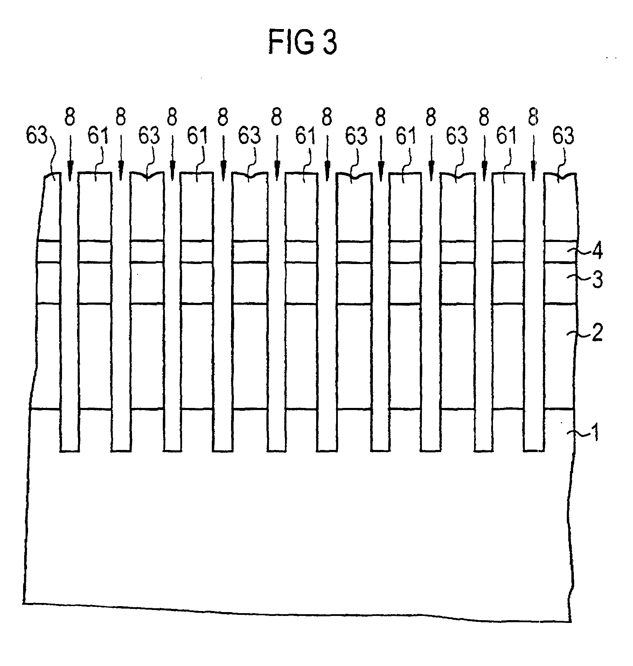

Unter Verwendung der strukturierten ersten Maskenschicht 61 und der strukturierten dritten Maskenschicht 63 als Ätzmaske werden in einem anisotropen Trockenätzprozeß erste Gräben 8 geätzt (siehe Figur 3). Dabei wird zunächst die Ätzstopschicht 71 durch anisotropes Ätzen mit CHF₃, O₂ entfernt. Als Ätzprozeß für die Siliziumätzung ist zum Beispiel HBr, NF₃, He, O₂ geeignet. Die ersten Gräben 8 werden mit einer Tiefe von zum Beispiel 1000 nm erzeugt. Damit reichen die ersten Gräben 8 bis in den p-dotierten Bereich 1 des Halbleitersubstrats. Die ersten Gräben 8 durchtrennen die erste Schicht 2, die zweite Schicht 3 und die dritte Schicht 4. Parallel zur Hauptfläche 5 weisen die ersten Gräben 8 einen streifenförmigen Querschnitt auf. Die ersten Gräben 8 verlaufen im wesentlichen parallel über das gesamte Zellenfeld. Die ersten Gräben 8 weisen eine Weite von zum Beispiel 90 nm und eine Länge von 64 µm auf. Der Abstand zwischen den Mitten benachbarter erster Gräben 8 beträgt zum Beispiel 250 nm, das entspricht der minimalen Strukturgröße F = 250 nm in der verwendeten Technologie.

Durch naßchemisches Ätzen zum Beispiel mit NH₄F(30%)/HF(6%) werden anschließend die strukturierte erste Maskenschicht 61 und die strukturierte dritte Maskenschicht 63 entfernt.

Durch Abscheidung einer SiO₂-Schicht in einem TEOS-Verfahren mit einer Schichtdicke von 100 nm werden die ersten Gräben 8 mit einer ersten Isolationsstruktur 9 aufgefüllt. Zur Bildung der ersten Isolationsstruktur 9 wird die SiO₂-Schicht rückgeätzt und planarisiert, bis außerhalb der Gräben 8 die Hauptfläche 5 freigelegt wird. Das Rückätzen erfolgt in einem Trockenätzprozeß, zum Beispiel mit CHF₃, O₂.

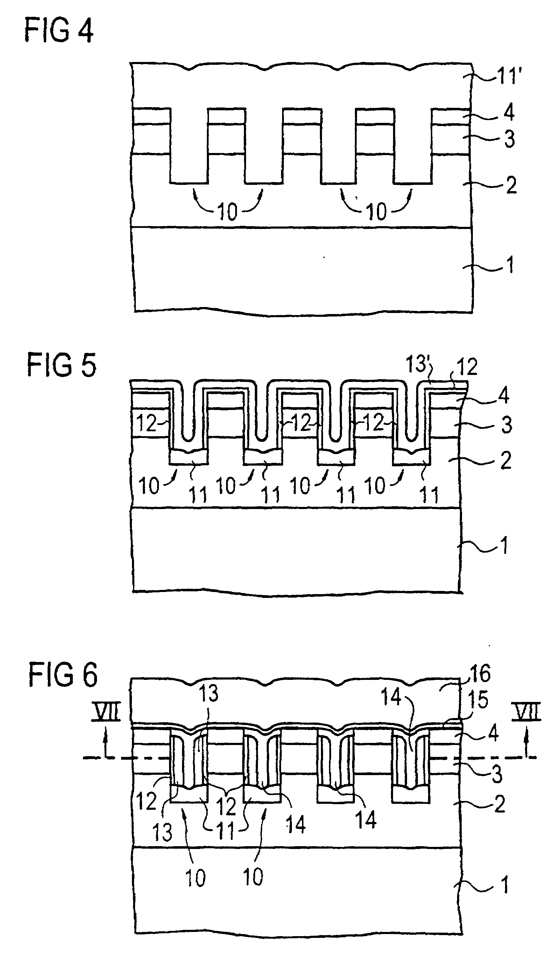

Anschließend wird eine weitere Maske mit Hilfe photolithographischer Verfahren erzeugt, die als Ätzmaske zum Ätzen zweiter Gräben 10 verwendet wird (siehe Figur 4). Zur Bildung der zweiten Gräben 10 muß ein Ätzverfahren verwendet werden, das Silizium selektiv zu SiO₂ angreift. Insbesondere ist dazu HBr, Cl₂, He, O₂ geeignet. Die zweiten Gräben 10 verlaufen zum Beispiel senkrecht zu den ersten Gräben 8 (Figur 4 zeigt einen zu Figur 3 senkrechten Schnitt durch die Anordnung). Um später Kurzschlüsse zu vermeiden, ist es wesentlich, daß bei der Ätzung der zweiten Gräben 10 das Silizium an Seitenwänden der ersten Isolationsstruktur 9 rückstandsfrei entfernt wird. Um dieses sicherzustellen, kann nach dem anisotropen Trokkenätzen noch ein Naßätzschritt mit zum Beispiel Cholin angefügt werden. Die zweiten Gräben 10 werden in einer Tiefe von zum Beispiel 500 nm geätzt. Die zweiten Gräben 10 reichen bis in die erste Schicht 2 hinein, ohne diese jedoch zu durchtrennen. In der fertigen DRAM-Zellenanordnung wirkt der durchgehende Teil der ersten Schicht 2 jeweils als Bitleitung. Parallel zur Hauptfläche 5 weisen die zweiten Gräben 10 einen streifenförmigen Querschnitt auf. Sie verlaufen im wesentlichen parallel und weisen eine Weite von 250 nm und eine Länge von 128 µm auf. Der Abstand der Mitten benachbarter zweiter Gräben 10 beträgt zum Beispiel 500 nm, das heißt 2F.

Nach Entfernen der Maske werden die zweiten Gräben 10 durch Abscheidung einer SiO₂-Schicht 11' in einem TEOS-Verfahren in einer Schichtdicke von zum Beispiel 300 nm aufgefüllt.

Durch anisotropes Trockenätzen, zum Beispiel mit CHF₃, O₂ wird die SiO₂-Schicht 11' rückgeätzt. Dabei werden in den zweiten Gräben 10 zweite Isolationsstrukturen 11 gebildet (siehe Figur 5). Der anisotrope Trockenätzprozeß greift SiO₂ selektiv zu Silizium an. Der Ätzprozeß wird fortgesetzt, bis die Oberfläche der zweiten Isolationsstrukturen 11 400 nm unter der Hauptfläche 5 liegt. In diesem Trockenätzprozeß werden auch die ersten Isolationsstrukturen 9 angegriffen, deren Oberfläche nach dem Trockenätzprozeß in der gleichen Höhe wie die der zweiten Isolationsstruktur 11 liegt. Bei dem Rückätzen werden in den ersten Gräben 8 und in den zweiten Gräben 10 die an die Flanken des jeweiligen Grabens angrenzenden Oberflächen der dritten Schicht 4 und der zweiten Schicht 3 vollständig freigelegt. Falls erforderlich kann dieses durch einen zusätzlichen Naßätzschritt, zum Beispiel mit HF(1%) sichergestellt werden.

Zur Bildung eines Gateoxids 12 an der Oberfläche der zweiten Schicht 3 wird anschließend eine thermische Oxidation bei zum Beispiel 800°C durchgeführt. Das Gateoxid 12 wird in einer Dicke von zum Beispiel 5 nm gebildet. Bei der thermischen Oxidation bildet sich an allen freiliegenden Siliziumoberflächen eine 5 nm dicke SiO₂-Schicht. Schließlich wird eine in situ dotierte Polysiliziumschicht 13' abgeschieden. Die dotierte Polysiliziumschicht, die zum Beispiel durch Phosphor n-dotiert ist mit einer Dotierstoffkonzentration von 10²¹ cm⁻³, wird in einer Dicke von 80 nm abgeschieden (siehe Figur 5). Die dotierte Polysiliziumschicht 13' wird mit konformer Kantenbedeckung abgeschieden. Dadurch werden die zweiten Gräben 10 nicht aufgefüllt. Die ersten Gräben 8, die eine geringere Weite als die zweiten Gräben 10 aufweisen, werden dabei jedoch aufgefüllt.

Zur Bildung von Gateelektroden 13 wird die dotierte Polysiliziumschicht 13' in einem anisotropen Trockenätzprozeß rückgeätzt. Dabei wird in den zweiten Gräben 10 die Oberfläche der zweiten Isolationsstruktur 11 freigelegt. Der in den zweiten Gräben 10 angeordnete Teil der Gateelektroden 13 entsteht als Spacer entlang der Flanken der zweiten Gräben 10. Die anisotrope Ätzung erfolgt zum Beispiel mit HBr, Cl₂, He, O₂, wobei eine Polysiliziumdicke von 150 nm geätzt wird. Das heißt, die Ätzung ist stark überzogen, so daß die mit Gateoxid bedeckten Flanken der dritten Schicht 4 im Bereich der zweiten Gräben 10 freigelegt werden (siehe Figur 6). Die bei der Gateoxidation gebildete dünne SiO₂-Schicht an der Oberfläche der dritten Schicht 4 im Bereich der Hauptfläche 5 wirkt bei dem anisotropen Ätzen als Ätzstop.

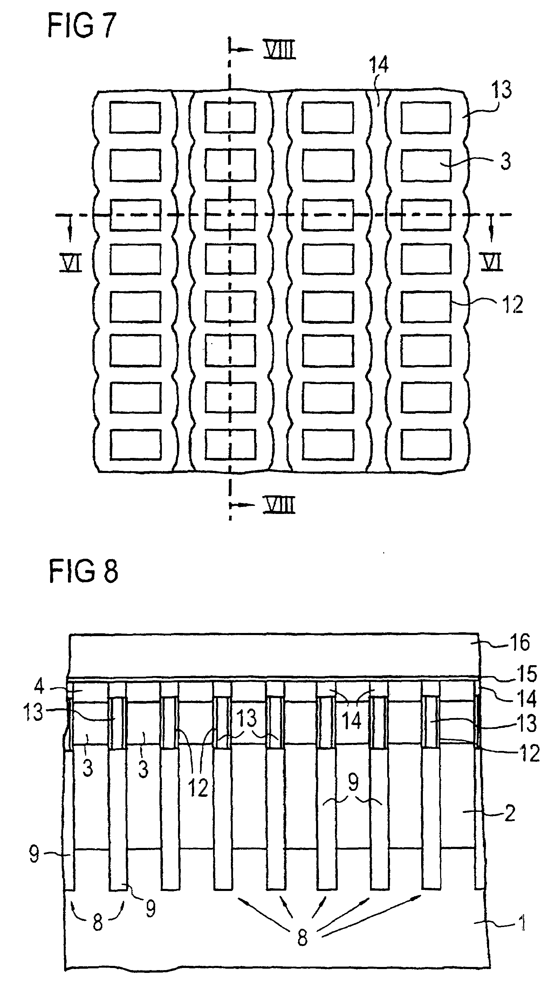

Bei der anisotropen Ätzung zur Bildung der Gateelektroden 13 wird die dotierte Polysiliziumschicht 13' in den ersten Gräben 8, die von der dotierten Polysiliziumschicht 13' aufgefüllt sind, bis unterhalb der Höhe der Hauptfläche 5 rückgeätzt (siehe Figur 6 und Figur 8). Die Gateelektroden 13 umgeben jeweils ein durch zwei benachbarte erste Gräben und zwei benachbarte zweite Gräben begrenztes Teil der zweiten Schicht 3 ringförmig (siehe Figur 7). Wegen der geringeren Weite der ersten Gräben 8 sind benachbarte Gateelektroden 13 über den im jeweiligen ersten Graben 8 angeordneten Teil miteinander verbunden.

Es wird eine weitere SiO₂-Schicht in einem TEOS-Verfahren in einer Schichtdicke von zum Beispiel 150 nm abgeschieden und in einem Trockenätzverfahren anisotrop rückgeätzt. Dadurch werden dritte Isolationsstrukturen 14 erzeugt. Die dritten Isolationsstrukturen 14 isolieren Gateelektroden 13, die an gegenüberliegenden Flanken ein- und desselben zweiten Grabens 10 angeordnet sind, gegeneinander (siehe Figur 6). In den ersten Gräben decken die dritten Isolationsstrukturen 14 die Gateelektroden 13 ab(siehe Figur 8). Die zweiten Gräben 10 werden ebenfalls durch die dritten Isolationsstrukturen 14 im wesentlichen aufgefüllt(siehe Figur 6). Es verbleibt lediglich eine geringe Unebenheit, die durch Abscheidung der SiO₂-Schicht in größerer Dicke vermieden werden kann.

Anschließend wird ein Kondensatordielektrikum 15 aufgebracht. Das Kondensatordielektrikum 15 wird aus einem Material mit hoher relativer Dielektrizitätskonstante εᵣ erzeugt. Vorzugsweise wird das Kondensatordielektrikum 15 aus Barium-Strontium-Titanat, Strontium-Titanat oder Blei-Zirkon-Titanat gebildet. Diese ferroelektrischen und paraelektrischen Schichten werden zum Beispiel durch Sputtern, im CVD-Verfahren oder Sol-Gel-Verfahren aufgebracht. Das Kondensatordielektrikum 15 wird in einer Schichtdicke von zum Beispiel 50 nm erzeugt.

In Fällen, in denen eine Beeinträchtigung des Siliziums der dritten Schicht 4 durch das Material des Kondensatordielektrikums 15 zu befürchten ist, liegt es im Rahmen der Erfindung, zwischen der dritten Schicht 4 und dem Kondensatordielektrikum 15 eine Zwischenschicht aus zum Beispiel TiN, Pt, W oder RuO₂ vorzusehen.

Für den Fall, daß Leckströme in dem Kondensatordielektrikum für eine Speicheranwendung nicht hinnehmbar sind, kann das Kondensatordielektrikum strukturiert werden. Dazu ist jedoch eine zusätzliche Maske erforderlich.

Auf das Kondensatordielektrikum wird ganzflächig eine Kondensatorplatte 16 aufgebracht. Dazu wird eine leitfähige Schicht, zum Beispiel aus TiN, Pt, W, RuO₂ oder n⁺-dotiertem Polysilizium abgeschieden. Die Kondensatorplatte 16 wird in einer Dicke von zum Beispiel 100 nm gebildet.

In der DRAM-Zellenanordnung umfaßt jede Speicherzelle einen Auslesetransistor, der aus dem vertikalen MOS-Transistor, der jeweils durch benachbarte erste Gräben und benachbarte zweite Gräben begrenzt ist und den dort angeordneten Teil der ersten Schicht 2 als Source/Drain-Gebiet, der zweiten Schicht 3 als Kanalgebiet und der dritten Schicht 4 als Source/Drain-Gebiet umfaßt. Der durchgehende Teil der ersten Schicht 2 (siehe Figur 6) wirkt als Bitleitung. Senkrecht zur Bitleitungsrichtung benachbarte Gateelektroden 13, die im Bereich der ersten Gräben 8 miteinander verbunden sind, bilden vergrabene Wortleitungen. In Bitleitungsrichtung benachbarte Wortleitungen sind durch die dritte Isolationsstruktur gegeneinander isoliert. Die Speicherzellen umfassen ferner einen Speicherkondensator, der aus dem jeweiligen Teil der dritten Schicht 4 als Speicherknoten, dem Kondensatordielektrikum 15 und der Kondensatorplatte 17 gebildet wird.

Zur Herstellung der DRAM-Zellenanordnung sind nur zwei Masken erforderlich: die erste Maske zur Strukturierung der ersten Maskenschicht und der zweiten Maskenschicht, die zweite Maske zum Ätzen der zweiten Gräben 10. Werden die Strukturen in beiden Masken entsprechend der minimal herstellbaren Strukturgröße F in der jeweiligen Technologie hergestellt, so beträgt der Abstand der Mitten benachbarter erster Gräben 8 F und zweiter Gräben 10 2F und es ergibt sich pro Speicherzelle ein Platzbedarf von 2F². Bei Zugrundelegen einer Technologie mit F = 0,25 µm ergibt sich ein Platzbedarf pro Speicherzelle von 0,125 µm². Die beiden verwendeten lithographisch erzeugten Masken sind bezüglich ihrer Justierung unkritisch. Zur Strukturierung der Gateelektroden und damit der Wortleitung ist keine weitere Maske erforderlich.

## Patentansprüche

1. Verfahren zur Herstellung einer DRAM-Zellenanordnung,
- bei dem auf ein Halbleitersubstrat, das eine erste Schicht (2), die von einem ersten Leitfähigkeitstyp dotiert ist, eine zweite Schicht (3), die von einem zweiten, zum ersten entgegengesetzten Leitfähigkeitstyp dotiert ist, und eine dritte Schicht (4), die vom ersten Leitfähigkeitstyp dotiert ist und die an eine Hauptfläche (5) des Halbleitersubstrats angrenzt, umfaßt, eine erste Maskenschicht und eine zweite Maskenschicht aufgebracht werden, die zueinander selektiv ätzbar sind,
- bei dem die zweite Maskenschicht und die erste Maskenschicht gemeinsam strukturiert werden,
- bei dem durch selektives Ätzen die strukturierte erste Maskenschicht (61) unter die strukturierte zweite Maskenschicht (62) zurückgeätzt wird,
- bei dem die strukturierte zweite Maskenschicht (62) entfernt wird,
- bei dem an den Flanken der strukturierten ersten Maskenschicht (61) Spacer (72) aus einem Material gebildet werden, das zu dem Material der strukturierten ersten Maskenschicht (61) selektiv ätzbar ist,
- bei dem eine dritte Maskenschicht (63') mit im wesentlichen konformer Kantenbedeckung aufgebracht wird, die die gleichen Ätzeigenschaften wie die erste Maskenschicht aufweist,
- bei dem die dritte Maskenschicht (63') selektiv zu den Spacern (72) zurückgeätzt wird, bis die Oberfläche der Spacer (72) teilweise freigelegt ist,
- bei dem die Spacer selektiv zur strukturierten ersten Maskenschicht (61)und zur strukturierten dritten Maskenschicht (63) entfernt werden,
- bei dem unter Verwendung der strukturierten ersten Maskenschicht (61)und der strukturierten dritten Maskenschicht (63) als Ätzmaske erste Gräben (8), die jeweils streifenförmig sind und im wesentlichen parallel verlaufen und die die erste Schicht (2), die zweite Schicht (3) und die dritte Schicht (4) durchtrennen, geätzt werden,
- bei dem die ersten Gräben (8) mit einer ersten Isolationsstruktur (9) aufgefüllt werden,
- bei dem zweite Gräben (10), die jeweils streifenförmig sind und im wesentlichen parallel verlaufen, die die ersten Gräben (8) kreuzen und die bis in die erste Schicht (2) hineinreichen, ohne die erste Schicht (2) zu durchtrennen, geätzt werden,
- bei dem die zweiten Gräben (10) mit einer zweiten Isolationsstruktur (11) versehen werden,
- bei dem die Weite der zweiten Gräben (10) größer als die Weite der ersten Gräben (8) ist,
- bei dem die ersten Isolationsstrukturen (9) und die zweiten Isolationsstrukturen (11) selektiv zu dem Halbleitermaterial geätzt werden, bis an den Flanken der ersten Gnäben (8) und der zweiten Gräben (10) die Oberfläche der strukturierten zweiten Schicht (3) und dritten Schicht (4) freigelegt sind,
- bei dem ein Gateoxid (12) gebildet wird, das mindestens die freiliegende Oberfläche der zweiten Schicht (3) bedeckt,
- bei dem zur Bildung von Gateelektroden (13) eine leitfähige Schicht (13') mit im wesentlichen konformer Kantenbedeckung erzeugt wird, deren Dicke so bemessen wird, daß sie die ersten Gräben (8) auffüllt, die zweiten Gräben (10) jedoch nicht auffüllt, und die anisotrop rückgeätzt wird, so daß an den Flanken der zweiten Gräben leitfähige Spacer entstehen und in den zweiten Gräben die Oberfläche der zweiten Isolationsstrukturen (11) teilweise freigelegt wird, während die Oberfläche der ersten Isolationsstruktur in den ersten Gräben (8) von leitfähigem Material bedeckt bleibt,
- bei dem eine dritte Isolationsstruktur (14) erzeugt wird, die die Gateelektroden (13) abdeckt,
- bei dem Speicherkondensatoren jeweils mit einem Speicherknoten erzeugt werden, der mit der strukturierten, dritten Schicht (4) elektrisch verbunden wird.

2. Verfahren nach Anspruch 1,
bei dem die erste Maskenschicht und die dritte Maskenschicht jeweils aus SiO₂ und die zweite Maskenschicht und die Spacer (72) jeweils aus Si₃N₄ gebildet werden und die leitfähige Schicht aus dotiertem Polysilizium gebildet wird.

3. Verfahren nach Anspruch 1 oder 2,
- bei dem das Halbleitersubstrat mindestens im Bereich der Hauptfläche monokristallines Silizium umfaßt,
- bei dem die erste Schicht (2), die zweite Schicht (3) und die dritte Schicht (4) epitaktisch aufgewachsen werden.

4. Verfahren nach Anspruch 3,
bei dem unter der ersten Schicht (2) eine leitfähige Schicht aus epitaktisch aufgewachsenem CoSi₂ erzeugt wird, die bei der Ätzung der ersten Gräben (8) durchtrennt wird.

5. Verfahren nach einem der Ansprüche 1 bis 4,
bei dem zur Bildung der Speicherkondensatoren oberhalb der strukturierten dritten Schicht (4) ein Kondensatordi.elektrikum (15) und eine Kondensatorplatte (16) aufgebracht werden, so daß die strukturierte dritte Schicht (4) gleichzeitig als Speicherknoten wirkt.

6. Verfahren nach Anspruch 5,
bei dem das Kondensatordielektrikum (15) aus einem der Stoffe Barium-Strontium-Titanat, Strontium-Titanat oder Blei-Zirkon-Titanat gebildet wird.

7. Verfahren nach Anspruch 5 oder 6,
bei dem das Kondensatordielektrikum (15) als durchgehende Schicht gebildet wird.

## Claims

1. Method for the production of a DRAM cell arrangement,
- in which a first mask layer and a second mask layer, which can be etched selectively with respect to one another, are applied to a semiconductor substrate comprising a first layer (2), which is doped by a first conductivity type, a second layer (3), which is doped by a second conductivity type opposite to the first, and a third layer (4), which is doped by the first conductivity type and adjoins a main area (5) of the semiconductor substrate,
- in which the second mask layer and the first mask layer are structured jointly,
- in which the structured first mask layer (61) is etched back under the structured second mask layer (62) by means of selective etching,
- in which the structured second mask layer (62) is removed,
- in which spacers (72) made of a material which can be etched selectively with respect to the material of the structured first mask layer (61) are formed on the flanks of the structured first mask layer (61),
- in which a third mask layer (63') having essentially conformal edge covering is applied, it having the same etching properties as the first mask layer,
- in which the third mask layer (63') is etched back selectively with respect to the spacers (72) until the surface of the spacers (72') is partially exposed,
- in which the spacers are removed selectively with respect to the structured first mask layer (61) and with respect to the structured third mask layer (63),
- in which, using the structured first mask layer (61) and the structured third mask layer (63) as an etching mask, first trenches (8) are etched, which first trenches are each in strip form, run essentially parallel and cut through the first layer (2), the second layer (3) and the third layer (4),
- in which the first trenches (8) are filled with a first insulation structure (9),
- in which second trenches (10) are etched, which second trenches are each in strip form, run essentially parallel, cross the first trenches (8) and reach down into the first layer (2) without cutting through the first layer (2),
- in which the second trenches (10) are provided with a second insulation structure (11),
- in which the width of the second trenches (10) is greater than the width of the first trenches (8),
- in which the first insulation structures (9) and the second insulation structures (11) are etched selectively with respect to the semiconductor material until the surface [sic] of the structured second layer (3) and third layer (4) are exposed on the flanks of the first trenches (8) and of the second trenches (10),
- in which a gate oxide (12) is formed, which gate oxide covers at least the exposed surface of the second layer (3),
- in which, in order to form gate electrodes (13), a conductive layer (13') having essentially conformal edge covering is produced, the thickness of which conductive layer is dimensioned such that it fills the first trenches (8) but does not fill the second trenches (10), and which conductive layer is etched back anisotropically such that conductive spacers are produced on the flanks of the second trenches and the surface of the second insulation structures (11) is partially exposed in the second trenches, while the surface of the first insulation structure in the first trenches (8) remains covered by conductive material,
- in which a third insulation structure (14), which covers the gate electrodes (13), is produced,
- in which storage capacitors are produced which each have a storage node which is electrically connected to the structured third layer (4).

2. Method according to Claim 1,
in which the first mask layer and the third mask layer are each formed from SiO₂ and the second mask layer and the spacers (72) are each formed from Si₃N₄, and the conductive layer is formed from doped polysilicon.

3. Method according to Claim 1 or 2,
- in which the semiconductor substrate comprises monocrystalline silicon at least in the region of the main area,
- in which the first layer (2), the second layer (3) and the third layer (4) are grown on epitaxially.

4. Method according to Claim 3,
in which a conductive layer made of CoSi₂, grown on expitaxially, is produced under the first layer (2) and is cut through during the etching of the first trenches (8).

5. Method according to one of Claims 1 to 4,
in which, in order to form the storage capacitors, a capacitor dielectric (15) and a capacitor plate (16), are applied above the structured third layer (4), with the result that the structured third layer (4) simultaneously acts as a storage node.

6. Method according to Claim 5,
in which the capacitor dielectric (15) is formed from one of the materials barium strontium titanate, strontium titanate or lead zirconium titanate.

7. Method according to Claim 5 or 6,
in which the capacitor dielectric (15) is formed as a continuous layer.

## Revendications

1. Procédé pour fabriquer un dispositif à cellules DRAM,
- selon lequel on dépose une première couche de masquage et une seconde couche de masquage, qui peuvent être attaquées sélectivement l'une par rapport à l'autre, sur un substrat semiconducteur, qui comporte une première couche (2), qui est dopée par un premier type de conductivité, une seconde couche (3), qui est dopée par un second type de conductivité opposé au premier, une troisième couche (4), qui est dopée par le premier type de conductivité et jouxte une surface principale (5) du substrat semiconducteur,
- selon lequel on structure en commun la seconde couche de masquage et la première couche de masquage,
- selon lequel on réalise, au moyen d'une attaque sélective, l'attaque en retrait de la première couche de masquage structurée (61) au-dessous de la seconde couche de masquage structurelle (62),
- selon lequel on élimine la seconde couche de masquage structurée (62),
- selon lequel on forme, sur les flancs de la première couche de masquage structurée (61), des espaceurs (72) formées d'un matériau, qui peut être attaqué sélectivement par rapport au matériau de la première couche de masquage structurée (61),
- selon lequel on applique une troisième couche de masquage (63') avec un revêtement de bord sensiblement conforme, cette couche possédant les mêmes caractéristiques d'attaque que la première couche de masquage,
- selon lequel on attaque en retrait sélectivement par rapport aux espaceurs (72) la troisième couche de masquage (63') jusqu'à ce que la surface de l'espaceur (72) soit partiellement mise à nu,
- selon lequel on élimine les espaceurs sélectivement par rapport à la première couche de masquage structurée (61) et par rapport à la troisième couche de masquage structurée (63),
- selon lequel moyennant l'utilisation de la première couche de masquage structurée (61) et la troisième couche de masquage structurée (63), on forme par attaque, en tant que masque d'attaque, des premiers sillons (8), qui sont réalisés respectivement en forme de bandes, s'étendent sensiblement parallèlement entre eux et traversent la première couche (2), la seconde couche (3) et la troisième couche (4),
- selon lequel on remplit les premiers sillons (8) par une première structure isolante (9),
- selon lequel on forme par attaque des seconds sillons (10), qui sont réalisés respectivement en forme de bandes et sensiblement parallèlement et croisent les premiers sillons (8) et s'étendent jusque dans la première couche (2) sans traverser la première couche (2),
- selon lequel on équipe les seconds sillons (10) d'une seconde structure isolante (11),
- selon lequel la largeur des seconds sillons (10) est supérieure à la largeur des premiers sillons (8),
- selon lequel on attaque sélectivement les premières structures isolantes (9) et les secondes structures isolantes (11) par rapport au matériau semiconducteur jusqu'à ce que la surface de la seconde couche structurée (3) et de la troisième couche structurée (4) soient mises à nu au niveau des flancs des premiers sillons (8) et des seconds sillons (10),
- selon lequel on forme un oxyde de grille (12), qui recouvre au moins la surface mise à nu de la seconde couche (3),
- selon lequel pour former des électrodes de grille (13) on forme une couche conductrice (13') comportant un revêtement de bord sensiblement conforme, dont l'épaisseur est dimensionnée de telle sorte qu'elle remplit les premiers sillons (8) mais ne remplit pas les seconds sillons (10), et qui est attaqué en retrait de façon anisotrope de sorte que des espaceurs conducteurs apparaissent sur les flancs des deux sillons et que la surface des secondes structures isolantes (11) est partiellement mise à nu dans les seconds sillons, tandis que la surface de la première structure isolante reste recouverte par le matériau conducteur dans les premiers sillons (8),
- selon lequel on forme une troisième structure isolante (14), qui recouvre les électrodes de grille (13),
- selon lequel on forme les condensateurs de mémoire respectivement avec un noeud de mémoire, qui est relié électriquement à la troisième couche structurée (4).

2. Procédé selon la revendication 1, selon lequel on forme la première couche de masquage et la troisième couche de masquage respectivement en SiO₂ et la seconde couche de masquage et les espaceurs (72) respectivement en Si₃N₄, et on forme la couche conductrice avec du polysilicium dopé.

3. Procédé selon la revendication 1 ou 2
- selon lequel le substrat semiconducteur comporte du silicium polycristallin au moins au niveau de la surface principale,
- selon lequel on forme la première couche (2), la seconde couche (3) et la troisième couche (4) par croissance épitaxiale.

4. Procédé selon la revendication 3,
selon lequel au-dessous de la première couche (2) on forme une couche conductrice constituée de CoSi₂ formé par croissance épitaxiale, qui est sectionnée lors de l'attaque des premiers sillons (8).

5. Procédé selon les revendications 1 à 4, selon lequel pour la formation des condensateurs de mémoire on dépose, au-dessus de la troisième couche structurée (4), un diélectrique de condensateur (15) et une plaque de condensateur (16) de telle sorte que la troisième couche structurée (4) agit simultanément en tant que noeud de mémoire.

6. Procédé selon la revendication 5, selon lequel le diélectrique de condensateur (15) est formé par l'un des matériaux comprenant le titanate de baryum et de strontium, le titanate de strontium ou le titane de plomb et de zirconium.

7. Procédé selon la revendication 5 ou 6, selon lequel le diélectrique (15) du condensateur est agencé sous la forme d'une couche continue.
